# FASCICULE DE BREVET EUROPEEN

(11) **EP 0 737 255 B1**
(45) Date de publication et mention de la délivrance du brevet: **28.04.1999**
(21) Numéro de dépôt: 95906362.9
(22) Date de dépôt: 04.01.1995
(51) Int. Cl.: C23C 14/10, C23C 16/40

(54) **BANDE A BASE D'ALUMINIUM REVETUE, RESISTANT A LA CORROSION ET DEFORMABLE**
DEFORMIERBARE KORROSIONSFESTE BESCHICHTETE ALUMINIUMBAHN
FLEXIBLE, CORROSION-RESISTANT COATED ALUMINIUM-BASED STRIP

(30) Priorité: 07.01.1994 FR 9400293
(43) Date de publication de la demande: 16.10.1996
(73) Titulaire: Société Anonyme de Traitement des Métaux et Alliages (SATMA), 38570 Goncelin (FR)
(72) Inventeur: BENMALEK, Mohamed, F-38400 Saint-Martin-d'Hères (FR); ALLEGRET, Francis, F-38570 Goncelin (FR)
(74) Mandataire: Mougeot, Jean-Claude
(86) Numéro de dépôt international: FR9500005
(87) Numéro de publication internationale: WO9518878

(56) Documents cités:
- US-A- 4 379 196
- PATENT ABSTRACTS OF JAPAN vol. 007 no. 089 (M-207) ,13 Avril 1983 & JP,A,58 013945 (MATSUSHITA DENKI SANGYO KK) 26 Janvier 1983,
- JOURNAL OF APPLIED PHYSICS, JUNE 1981, USA, VOL. 52, NR. 6, PAGE(S) 4205 - 4220, ISSN 0021-8979, GRANQVIST C G ET AL 'Radiative cooling to low temperatures: general considerations and application to selectively emitting SiO films'
- PATENT ABSTRACTS OF JAPAN vol. 012 no. 301 (C-521) ,16 Août 1988 & JP,A,63 072868 (NIPPON STEEL CORP) 2 Avril 1988,

## Description

### DOMAINE TECHNIQUE

L'invention concerne des bandes généralement à usage réfléchissant ou de décoration, à base d'aluminium ou de ses alliages, recouvertes d'un dépôt protecteur contre la corrosion, et aptes à être mises en oeuvre par formage sans altération de la protection.

### ETAT DE LA TECHNIQUE

On sait que des bandes d'A1 réfléchissantes, utilisées par exemple comme réflecteurs dans le domaine de l'éclairage, comme miroir ou comme article de décoration nécessitant un grand brillant, ont besoin de conserver leur aspect brillant en cours d'usage. Ce brillant peut être terni à cause de la corrosion par l'atmosphère ambiante, du dépôt de fine poussière, de rayures, des traces de doigts etc...

Une façon de protéger ce brillant consiste à revêtir la surface brillante d'un revêtement transparent résistant à la corrosion, aux rayures..., ce revêtement devant altérer le moins possible le brillant initial.

Ainsi on connait par le brevet JP 58 013945 une feuille d'aluminium de forme concave, recouverte d'oxyde de silicium et installée comme réflecteur dans un radiateur à infrarouge.

On sait également que pour obtenir des bandes lisses refléchissantes un procédé classique consiste à effectuer, sur une bande d'alliage d'A1 laminée grand brillant, un décapage électrochimique puis un brillantage également électrochimique avant une anodisation électrochimique destinée à obtenir une pellicule protectrice d'alumine. Une bande ainsi protégée peut alors être mise en forme par exemple, par déformation, pliage, emboutissage, découpage..., pour confectionner les articles désirés, comme des réflecteurs pour appareils d'éclairage ou de chauffage, de miroirs, des pièces brillantes à effet décoratif (conditionnement de produits cosmétiques de luxe, articles de finition pour automobile...)

Ce procédé de brillantage électrochimique et d'anodisation ou d'anodisation seule s'applique également à des bandes d'A1 ayant un autre aspect de surface (par exemple mat) en vue d'améliorer son rendu et sa protection.

Cependant, pour obtenir des bandes lisses brillantes, une telle solution présente plusieurs inconvénients:
- il est nécessaire, d'utiliser des alliages d'A1 de haut de gamme, typiquement des alliages au moins du type 1085 (dans la classification de l'Aluminum Association), qui seuls peuvent être brillantés par voie électrochimique ;
- la formabilité, qui représente l'aptitude de la bande revêtue de son dépôt protecteur d'alumine à être mise en forme par déformation sans altération dudit dépôt, est insuffisante ; en effet lorsqu'on veut pratiquer un pliage ou un emboutissage avec ou sans allongement et amincissement, il se produit un faïençage du revêtement d'alumine qui altère le brillant et la tenue à la corrosion de la bande revêtue.
- l'opération d'anodisation altère le brillant obtenu préalablement lors de l'opération de brillantage électrochimique
- les différentes opérations électrochimiques pratiquées sont une source d'effluents, préjudiciables à l'environnement, qu'il est nécessaire de traiter avant rejet.

Ainsi la demanderesse a cherché à mettre au point une bande à base d'aluminium, ayant un aspect de surface particulier préalablement obtenu par laminage par exemple, revêtue contre la corrosion, économique, se prêtant facilement au formage, par exemple par pliage, emboutissage, et à l'allongement en résultant, sans altérer sa protection et son aspect de surface initial.

Elle a aussi cherché à améliorer le brillant ou le réfléchissant des tôles revêtues, de même que leur tenue en atmosphère corrosive.

Elle a encore cherché à obtenir une bande revêtue peu sensible au dépôt de poussière ou autres salissures, comme les traces de doigt pouvant intervenir lors des manutentions, et également peu sensible aux rayures.

Elle a encore cherché à obtenir des articles ayant un aspect de surface particulier, réfléchissants ou non (en particulier des réflecteurs ou des articles de décoration) directement par travail mécanique d'une bande revêtue, par exemple par emboutissage, pliage..., conservant l'aspect de la bande initiale non revêtue et la qualité de protection dans le temps.

### DESCRIPTION DE L'INVENTION

L'invention est une bande à base d'aluminium, ou de ses alliages, non formée et plane revêtue d'une protection anticorrosion, ladite bande ayant une formabilité améliorée permettant de conserver intacts son aspect de surface et ladite protection anticorrosion après formage, caractérisée en ce que le revêtement est constitué d'une couche d'oxyde de silicium.

L'invention s'applique particulièrement aux bandes à base d'aluminium ou de ses alliages ayant un aspect de surface initial, décoratif ou non, obtenu généralement par laminage ou autre traitement physique. Cet aspect de surface est avantageusement l'aspect brillant, lisse et/ou réfléchissant, pour usage de miroir, réflecteur ou décoratif, mais il englobe également les aspects décoratifs des bandes à base d'aluminium comme le granité, le martelé, le mat, le sapin, le brossé, le lapidé, le brut de laminage (plus connu sous le vocable anglo-saxon de mill finish), etc... à usage par exemple également décoratif.

Les bandes selon l'invention peuvent servir à obtenir tous types d'articles, à l'aide d'opérations de formage classiques, y compris celles provoquant des déformations importantes, comme l'emboutissage ou le pliage, et conduisant à de forts allongements de la bande.

Ainsi, les pliures peuvent par exemple atteindre 180° avec de très petits rayons de courbure sans qu'apparaisse de faiençage de la pellicule d'oxyde de silicium et plus généralement sans que la qualité de la protection soit altérée; les rayons de courbure des pliures, et plus généralement les taux de déformation, ne sont limités que par les dommages provoqués à la bande elle-même.

Pour absorber ces déformations tout en conservant l'aspect initial ou le pouvoir réfléchissant de la bande avant revêtement, il est avantageux que l'épaisseur de la couche d'oxyde de silicium soit comprise entre 0,1 et 1,5 µm.

Si l'épaisseur est trop faible la pellicule protectrice d'oxyde de silicium résiste moins bien aux agressions (par exemple rayures) et présente des risques d'irisation ; de même les irrégularités de la surface du métal sont moins bien recouvertes et peuvent être l'amorce de détérioration. Par contre si l'épaisseur est trop importante, il y a des risques de fissuration de la pellicule quand on forme la bande, ce qui irait à l'encontre du but recherché.

La pellicule d'oxyde de silicium peut être la silice, mais il est hautement préférable d'utiliser un oxyde en sous-stoechiométrie du type SiOx avec x au moins égal à 1,8 et inférieur à 2 ou mieux d'au plus 1,9 ; une valeur de x inférieure à 2 permet, en évitant la rigidité de la silice, d'obtenir un maximum de souplesse de la pellicule pour qu'elle encaisse sans dommage les déformations de la bande lors de sa mise en forme, tandis qu'une valeur de x inférieure à 1,7 entraîne des risques sérieux de coloration et par conséquent une perte de réflectivité.

La couche peut être appliquée sur des bandes d'alliages d'A1 de tous types, pourvu qu'après laminage elles aient la qualité de surface souhaitée, par exemple réfléchissante. Il est donc très avantageux d'utiliser des alliages bon marché dont le choix est seulement limité par leur aptitude à donner l'aspect de surface voulu par laminage et/ou autre traitement physique préalable, les autres caractéristiques correspondant à l'usage envisagé.

Par alliage bon marché, on entend des alliages de type courant c'est-à-dire bas de gamme, les plus simples pouvant être de faible pureté (par exemple 1050) et/ou bruts de laminage à froid.

Ainsi pour obtenir, par exemple par emboutissage, pliage, ou tout autre type de formage, des réflecteurs destinés aux appareils d'éclairage ou de chauffage à partir des bandes de l'invention on peut utiliser des alliages de pureté inférieure à celle de l'alliage 1085 alors que, pour utiliser les procédés de protection de l'art antérieur, cette qualité est au moins nécessaire. A fortiori l'invention peut bien sûr s'appliquer à des alliages de pureté supérieure, entre autres ceux du type 1199 qui ont une qualité de brillant particulière.

De même pour des articles de décoration par exemple pour le domaine automobile ou le conditionnement, on peut utiliser des alliages de type courant pourvu que l'on ait l'aspect de surface recherché, comme cela a déjà été dit.

Il est à remarquer que, pour les applications réfléchissantes, on obtient des articles de meilleure qualité en effectuant directement un formage des bandes revêtues selon l'invention, plutôt que des articles obtenus en revêtant un substrat préformé (en plastique par exemple) d'une couche intermédiaire d'adhérence, d'un dépôt d'A1 devant assurer le brillant et enfin d'un dépôt protecteur de silice. Le formage d'une bande selon l'invention est en effet plus simple à mettre en oeuvre puisqu'il ne met en oeuvre qu'un seul dépôt sur une surface plane ; il permet également d'obtenir un meilleur brillant que celui obtenu par la succession de dépôts sur le susbstrat préformé et finalement les articles sont de meilleure qualité grâce au fait qu'on n'observe aucun des effets néfastes dûs à l'hétérogénéité des dépôts apparaissant dès que la forme dudit substrat est un peu complexe.

L'invention peut s'appliquer également à des bandes à base d'A1 dont l'une des faces est recouverte d'un matériau polymère, après ou de préférence avant déformation ; la face de référence est bien sur revêtue uniquement de la couche d'oxyde de silicium et est opposée à la face recouverte du matériau polymère.

Bien que le procédé puisse s'appliquer à des bandes dans un domaine d'épaisseur très large, pour les applications les plus courantes la bande selon l'invention a une épaisseur typiquement supérieure à 0,2 mm ; elle ne dépasse pas généralement 1,2 mm.

La bande selon l'invention est donc obtenue par dépôt direct d'une pellicule d'oxyde de silicium généralement sur une face d'une bande nue, préalablement laminée par les techniques habituelles. Mais selon l'invention, il est possible de faire un dépôt d'oxyde de silicium sur les 2 faces de la bande.

On utilise préférentiellement un procédé de dépôt en phase vapeur, la bande nue laminée étant avantageusement décapée au préalable pour améliorer l'adhérence dudit dépôt.

D'une manière générale, le décapage peut être effectué :
- par voie chimique à l'aide de solutions basiques (par exemple à base de soude) ou acides (mélange d'acides) ou par voie électrolytique;
- par voie thermique, pour éliminer les résidus organiques; le chauffage est de préférence effectué à une température supérieure à 250°C pour être suffisamment efficace. Un tel chauffage pouvant modifier les propriétés mécaniques du métal peut ne pas être recommandé dans certains cas;
- par chauffage sous vide, ce qui permet d'éviter l'emploi d'une température excessive ;

Mais il est avantageusement effectué par décapage ionique ; avec cette technique on obtient généralement une désorption complète des résidus carbonés sous vide, une élimination partielle de la couche d'oxyde (A1203) superficielle sans arriver jusqu'au métal; ceci permet d'éliminer les impuretés superficielles contenues dans ladite couche d'oxyde, de diminuer la rugosité de ladite couche, donc d'améliorer la réflectivité de la bande, et de laisser une surface décontaminée active qui améliore l'adhérence du dépôt d'oxyde de silicium ultérieur ; ce décapage ne se fait pas au détriment du métal de la bande à revêtir, comme c'est le cas dans le décapage et brillantage électrochimiques de l'art antérieur où le métal est souvent attaqué et où on génère en outre des boues préjudiciables à l'environnement qui doivent être traitées avant rejet en augmentant le coût du procédé.

Ainsi le décapage ionique peut améliorer la réflectance de la bande initiale jusqu'à prés de 20% et aussi diminuer la micro-rugosité de sa couche superficielle d'oxyde.

Dans le cas du décapage ionique la bande d'A1 peut être traitée au défilé dans une enceinte sous vide d'argon (pression en général inférieure à 10 Pa). Elle est portée à un potentiel négatif de façon à créer un champ électrique qui permet le bombardement de décapage avec les ions d'argon. Le décapage peut être amélioré en utilisant un champ éléctrique à Radio Fréquence (RF). La puissance doit être telle que ledit bombardement ne detèriore pas la surface (gravure, détachement de grain, décrochage, échauffement préjudiciable à ses caractéristiques....) La puissance est en général comprise entre 1 et 50 mW/mm2.

Pour obtenir la pellicule protectrice proprement dite, on effectue le dépôt d'oxyde de silicium de préférence au défilé par un procédé de PVD (Physical Vapor deposition).

Plusieurs techniques peuvent être utilisées :
- l'évaporation thermique par effet Joule ou induction
- l'évaporation par bombardement électronique
- de préférence la pulvérisation cathodique assistée par effet magnétron en mode radio-fréquence (RF) ou à courant continu (DC) selon que le matériau source est respectivement isolant ou conducteur électrique
- le dépôt ionique

Comme produit source à déposer on peut utiliser l'un au moins des produits tels que le silicium ou un oxyde de silicium du type SiOx avec x inférieur à 2. Selon la stoechiométrie du matériau de la source, il peut être recommandé d'opérer le dépôt en atmosphère réactive contenant de l'oxygène, pour obtenir la stoéchiométrie voulue dans le dépôt d'oxyde.

Dans le cas de la pulvérisation cathodique, assistée par effet magnétron en mode RF qui se révèle bien adaptée pour contrôler le dépôt, on bombarde sous très faible pression (en général inférieure à 10 Pa) une cible, par exemple d'oxyde de silicium, par un plasma d'ions d'Argon accélérés; les atomes de la cible ainsi pulvérisés vont former la pellicule sur la bande située en regard de ladite cible. Ce procédé de dépôt est avantageusement couplé avec le décapage ionique évoqué plus haut. La puissance utilisée dépend en général de l'équipement mis en oeuvre.

On peut faire subir un recuit à la bande recouverte du dépôt d'oxyde de façon à en améliorer l'adhérence et à augmenter l'aptitude du métal au formage. Un recuit peut également être obtenu lors du décapage ionique en contrôlant judicieusement cette opération ; ceci aura, pour effet à la fois d'améliorer l'adhérence du dépôt d'oxyde ultérieur, et l'aptitude du métal au formage (comme précédemment).

On note que ces procédés de dépôt du type PVD ne génèrent aucun effluent chimique.

A titre de variante, il est également possible d'augmenter le brillant de la bande nue de départ en effectuant les opérations de décapage et de brillantage chimiques et/ou électrochimiques décrites précédemment, préalablement au dépôt d'oxyde de silicium.

Pour illustrer l'invention, les essais suivants ont été réalisés sur un équipement de marque Alcaltel SCM 600 muni d'une cathode de 200 mm de diamètre.

On a pris des plaques d'alliage d'A1 bon marché du type 1050 (selon la norme de l'Aluminium Association) laminées brillant, d'épaisseur 0,5 mm et d'environ 100 cm2 de surface.

Elles ont été décapées par bombardement ionique dans les conditions suivantes:
Puissance totale RF : 700 W
Distance entre cible en matériau source et surface à revêtir : 70 mm Pression de l'enceinte sous vide : 1,5 Pa (0,015 mbar)
Flux de gaz inerte (Ar) : 70 cm3 standard/min
Durée: 2 minutes

Un dépôt à partir d'une cible de SiOx (avec x = 1,9) a été ensuite effectué dans les conditions suivantes:
Puissance totale RF : 700 W
Distance : cible - surface à revêtir : 70 mm
Pression de l'enceinte sous vide : 3 Pa (0,03 mbar)
Flux de gaz inerte (Ar) = 70 cm3 standard/min

On a fait varier la durée de l'opération pour obtenir deux épaisseurs de dépôt: 0,67 µm (échantillon 1) et 1,5 µm (échantillon 2).

L'analyse par spectroscopie de photoélectrons X, montre que le dépôt a la formule SiOx avec x proche de 1,8.

On a ensuite testé la tenue de ces plaques :
- à la rayure, à l'aide de crayons de duretés de mine différentes en partant du crayon le plus tendre 6B, en passant par les duretés moyennes croissantes B, HB, F, H et en allant au crayon le plus dur 9H.
- à la tenue aux brouillards salins (200 h) selon la norme française NF X 41002, les plaques étant planes ou ayant été pliées à 90° ou à 180° après l'opération de dépôt.

De même des plaques ont été revêtues d'un dépôt de SiO₂ à partir d'une cible en SiO₂.

A titre de comparaison les mêmes tests ont été effectués sur des échantillons plans et pliés, préalablement revêtus par un procédé habituel de l'art antérieur, c'est-à-dire des échantillons obtenus à partir d'une tôle haut de gamme du type 1098, laminée grand brillant puis décapée, brillantée et anodisée, le tout dans différents bains électrolytiques, pour obtenir une pellicule protectrice d'alumine.

Les résultats sont donnés dans le tableau 1 ci-après :

**TABLEAU 1**

| N° Echantillon | Réflectance après traitement % | Epaisseur du dépôt µm | Rayure | Brouillard salin (200 h) | | |
|---|---|---|---|---|---|---|
| | | | | surface plane | pliure à 90° | pliure à 180° |
| Invention (alliage 1050) | | SiOx x = 1,8 | | | | |
| 1 | 87 | 0,67 | HB | ++++ | ++++ | +++ |
| 2 | 85 | 1,5 x = 2 | H | ++++ | ++++ | +++ |
| 4 | 85 | 1,4 | HB | +++ | ++ | ++ |
| Art Antérieur (Alliage 1098) | | Al2O3 | | + (opaque) | + (opaque + piqures) | + (opaque+ piqures) |
| 3 | 89 | 2,5 µm | F | | | |

La réflectance de l'échantillon 3 de l'art antérieur à base d'alliage du type 1098 laminé grand brillant et celle des échantillons 1 et 2 à base d'alliage du type 1050 sont sensiblement les mêmes alors que l'alliage de départ utilisé selon l'invention est de moins bonne qualité.

La tenue aux rayures a été évaluée en notant la dureté à partir de laquelle on ne note plus de trace sur le dépôt après observation au microscope optique au grossissement x 50.

La tenue au brouillard salin est notée sur la surface plane et sur les lignes de pliure; une bonne tenue est repérée par (++++), un voile d'oxydation entraînant un aspect grisâtre ou un ternissement est noté (+). Les notations intermédiaires correspondent à : (+++) légère altération ou irisation de la surface, (++) voile d'oxydation apparent.

Il est à noter que dans le cas de l'invention (échantillons 1 et 2) les surfaces planes revêtues sont de très bonne qualité et que même sur les lignes de pliure la qualité est de même niveau; on ne note pas, en particulier, d'opacité ou de piqures sur les arêtes des pliures.

En ce qui concerne l'échantillon 4 on note encore une qualité qui peut être suffisante bien que, entre autre, la silice soit par elle-même moins efficace que les oxydes avec x < 2 pour protéger une surface plane et présente une moindre souplesse visible sur les résultats après pliage.

Par ailleurs des bandes d'aluminium de qualité 1050 brillant enroulées sur bobines ont été revêtues par traitement en continu au déroulé en obtenant une qualité équivalente.

Sur d'autres échantillons exposés 500 h au brouillard salin, on a obtenu des résultats équivalents.

L'invention est particulièrement intéressante parce que les bandes revêtues peuvent être ensuite travaillées en vue d'obtenir différents articles, ceux-ci conservant malgré cela une excellente qualité de brillant au cours du temps.

Comme cela a été vu, ces bandes sont particulièrement adaptées
- à la fabrication de réflecteurs pour appareils d'éclairage public ou privé, mais aussi pour appareil de chauffage par rayonnement,
- ou encore à la fabrication d'article de décoration par exemple des récipients dans l'industrie des produits de luxe, entre autres cosmétiques, des miroirs ou baguettes d'ornement pour l'automobile etc...

Ainsi les articles obtenus présentent-ils à la fois:
- une meilleure tenue à la corrosion de l'aspect de surface recherché, par exemple brillant, surtout à l'atmosphère extérieure, dans des ateliers, entrepôts... malgré les déformations subies par la bande revêtue lors de la confection de l'article,
- un prix de revient fortement diminué du fait que l'on peut employer des alliages d'aluminium courants, bon marché, et qu'aucun effluent à traiter n'est émis lors du procédé de fabrication.

Ils se distinguent aussi des articles préformés (par exemple à base d'aluminium) puis revêtu par une grande facilité d'obtention. Il est en effet plus aisé et économique de revêtir une bande selon l'invention puis de former les articles que de revêtir les articles une fois formés. Cet avantage s'accompagne d'une meilleure qualité de protection et de rendu d'aspect (brillant et pouvoir réfléchissant par exemple) car au cours de la formation de l'article l'aspect de surface recherché est protégé par la pellicule selon l'invention.

La bande et les articles selon l'invention se distinguent également des articles revêtus par des couches complexes d'oxydes, comportant de la silice, qui ont pour objet d'améliorer la réflectance du support. Ce n'est pas le cas de la présente invention où la pellicule sert à protéger un état de surface particulier de la bande avant et après déformation pour obtenir des articles correspondants sans en altérer l'aspect de surface.

De plus la bande selon l'invention, de même que les articles qui en sont issus, sont moins salissants ou susceptibles d'être ternis, en effets ils fixent significativement moins la poussière et les traces de doigt. De même la résistance à la rayabilité est au moins équivalente à celle des autres types de bandes revêtues, ce qui permet de les manipuler, emballer, nettoyer... sans risque d'en déteriorer l'aspect.

## Revendications

1. Bande à base d'aluminium, ou de ses alliages, non formée et plane revêtue d'une protection anticorrosion, ladite bande ayant une formabilité améliorée qui permet de conserver intacts son aspect de surface et sa protection après formage, caractérisée en ce que le revêtement est constitué d'une couche d'oxyde de silicium.

2. Bande selon la revendication 1 caractérisée en ce que les alliages d'aluminium sont des alliages de type courant.

3. Bande selon la revendication 2 caractérisée en ce que les alliages de type courant ont une pureté inférieure à celle des alliages 1085 (selon l'Aluminum Association).

4. Bande selon la revendication 1 caractérisée en ce que les alliages d'aluminium ont une pureté comprise entre celle des alliages 1085 et 1199.

5. Bande selon l'une quelconque des revendications 1 à 4 caractérisée en ce qu'elle est recouverte d'un matériau polymère sur la face opposée à la face réfléchissante revêtue de la couche d'oxyde de silicium.

6. Bande selon l'une quelconque des revendications 1 à 5 caractérisée en ce que la couche d'oxyde de silicium a une épaisseur comprise entre 0,1 et 1,5 µm.

7. Bande selon l'une quelconque des revendications 1 à 6 caractérisée en ce que l'oxyde de silicium répond à la formule SiOx, x étant au moins supérieur à 1,8 et inférieur à 2.

8. Bande selon l'une quelconque des revendications 1 à 7 caractérisé en ce que l'aspect de surface de ladite bande est lisse et réfléchissant.

9. Bande selon l'une quelconque des revendications 1 à 7 caractérisé en ce que l'aspect de surface de ladite bande est un aspect décoratif, de préférence granité, martelé, mat, sapin, brossé, lapidé ou brut de laminage (mill finish).

10. Procédé d'obtention des bandes de la revendication 1 caractérisé en ce qu'on décape une bande nue laminée, on y dépose une couche d'oxyde de silicium par PVD.

11. Procédé selon la revendication 10 caractérisé en ce que le décapage est chimique, électrochimique, ou thermique et de préférence ionique.

12. Procédé selon l'une quelconque des revendications 10 ou 11 caractérisé en ce que le procédé de PVD consiste à effectuer une pulvérisation cathodique assisté par magnétron et en mode Radio Fréquence.

13. Procédé selon l'une quelconque des revendications 10 à 11 caractérisé en ce que la bande subit un recuit soit lors du décapage, soit après dépôt de l'oxyde de silicium.

14. Application des bandes de la revendication 1 à l'obtention de pièces par opérations de formage classiques, de préférence par emboutissage et/ou pliage.

15. Application selon la revendication 14 caractérisée en ce que les pièces sont des réflecteurs pour appareil d'éclairage et/ou de chauffage.

16. Application selon la revendication 14 caractérisée en ce que les pièces sont des articles de décoration, de préférence dans le domaine du bâtiment, de l'automobile, du conditionnement.

## Patentansprüche

1. Ungeformte, ebene, mit einer Korrosionsschutzschicht versehene Bahn aus Aluminium oder seinen Legierungen, wobei die Bahn eine verbesserte Formbarkeit aufweist, durch welche ihr Oberflächenbild und ihr Schutz nach der Formgebung erhalten bleiben, dadurch gekennzeichnet, daß die Beschichtung aus einer Siliziumoxidschicht besteht.

2. Bahn nach Anspruch 1, dadurch gekennzeichnet, daß die Aluminiumlegierungen Legierungen üblichen Typs sind.

3. Bahn nach Anspruch 2, dadurch gekennzeichnet, daß die Legierungen üblichen Typs eine geringeren Reinheitsgrad haben als die Legierungen 1085 (gemäß Aluminium Association).

4. Bahn nach Anspruch 1, dadurch gekennzeichnet, daß die Aluminiumlegierungen einen Reinheitsgrad haben, der zwischen dem der Legierungen 1085 und 1199 liegt.

5. Bahn nach einem der Ansprüche 1 bis 4, dadurch gekennzeichnet, daß sie auf der Seite, die der reflektierenden, mit der Siliziumoxidschicht versehenen Seite gegenüberliegt, mit einem polymeren Werkstoff überzogen ist.

6. Bahn nach einem der Ansprüche 1 bis 5, dadurch gekennzeichnet, daß die Siliziumoxidschicht eine Dicke von 0,1 bis 1,5 µm aufweist.

7. Bahn nach einem der Ansprüche 1 bis 6, dadurch gekennzeichnet, daß das Siliziumoxid der Formel SiOx entspricht, wobei x mindestens größer als 1,8 und kleiner als 2 ist.

8. Bahn nach einem der Ansprüche 1 bis 7, dadurch gekennzeichnet, daß das Oberflächenbild der Bahn glatt und reflektierend ist.

9. Bahn nach einem der Ansprüche 1 bis 7, dadurch gekennzeichnet, daß das Oberflächenbild der Bahn dekorativ, vorzugsweise granitartig, gehämmert, matt, tannenartig, gebürstet, geschliffen oder roh gewalzt (mill finish) ist.

10. Verfahren zur Herstellung von Bahnen nach Anspruch 1, dadurch gekennzeichnet, daß eine gewalzte ungeschützte Bahn gebeizt und darauf im PVD-Verfahren eine Siliziumoxidschicht aufgebracht wird.

11. Verfahren nach Anspruch 10, dadurch gekennzeichnet, daß das Beizen chemisch, elektrochemisch oder thermisch und vorzugweise ionisch erfolgt.

12. Verfahren nach einem der Ansprüche 10 oder 11, dadurch gekennzeichnet, daß bei dem PVD-Verfahren eine magnetronunterstützte und im Radiofrequenzmodus erfolgende Kathodenzerstäubung durchgeführt wird.

13. Verfahren nach einem der Ansprüche 10 bis 11, dadurch gekennzeichnet, daß die Bahn entweder beim Beizen oder nach der Siliziumoxidabscheidung geglüht wird.

14. Verwendung der Bahnen nach Anspruch 1 zur Herstellung von Teilen mittels herkömmlicher Formgebungsverfahren, vorzugsweise durch Tiefziehen und/oder Biegen.

15. Verwendung nach Anspruch 14, dadurch gekennzeichnet, daß die Teile Reflektoren für Leuchten und/oder Heizgeräte sind.

16. Verwendung nach Anspruch 14, dadurch gekennzeichnet, daß die Teile Dekorationsartikel sind, vorzugzweise für den Gebäude-, Automobil- und Verpackungssektor.

## Claims

1. A strip based on aluminum or its alloys, non shaped and plane, coated with a means of anticorrosion protection, with said strip having an improved shaping capability allowing one to maintain its surface appearance and its protection intact after shaping, characterized by the fact that the coating consits of a layer of silicon oxide.

2. A strip according to Claim 1, characterized by the fact that the aluminum alloys are those of the ordinary type.

3. A strip according to Claim 2, characterized by the fact that the alloys of the ordinary type have a purity less than that of the 1085 alloy (according to the Aluminum Association).

4. A strip according to Claim 1, characterized by the fact that the aluminum alloys have a purity between that of the 1085 and 1199 alloys.

5. A strip according to any one of Claims 1 to 4, characterized by the fact that it is coated with a polymer material on the surface opposite the reflecting surface coated with the silicon oxide layer.

6. A strip according to any one of Claims 1 to 5, characterized by the fact that the silicon oxide layer has a thickness of 0.1-1.5 µm.

7. A strip according to any one of Claims 1 to 6, characterized by the fact that the silicon oxide corresponds to the formula SiOₓ, with x being at least greater than 1.8 and less than 2.

8. A strip according to any one of Claims 1 to 7, characterized by the fact that the surface appearance of said strip is smooth and of the reflecting type.

9. A strip according to any one of Claims 1 to 7, characterized by the fact that the surface appearance of said strip is a decorative appearance, preferably granite-like, beaten, dull, fir-like, brushed, stone-like, or rough after rolling (mill finish).

10. A process for obtaining the strips of Claim 1, characterized by the fact that a rolled bare strip is pickled, with a layer of silicon oxide being deposited on it by PVD.

11. A process according to Claim 10, characterized by the fact that the pickling is chemical, electrochemical, or thermal, but preferably ionic.

12. A process according to either of Claims 10 and 11, characterized by the fact that the PVD process consists of performing cathode sputtering assisted by a magnetron and in the radio-frequency mode.

13. A process according to either of Claims 10 and 11, characterized by the fact that the strip is subjected to annealing either during pickling or after deposition of the silicon oxide.

14. Application of the strips of Claim 1 toward obtaining parts by conventional shaping operations, preferably by embossing and/or bending.

15. Application according to Claim 14, characterized by the fact that the parts are reflectors for lighting and/or heating apparatuses.

16. Application according to Claim 14, characterized by the fact that the parts are decorative articles, and preferably in the construction, automobiles, and packaging fields.
